# EUROPEAN PATENT SPECIFICATION

(11) **EP 1 581 962 B1**
(45) Date of publication and mention of the grant of the patent: **19.12.2007**
(21) Application number: 04700556.6
(22) Date of filing: 07.01.2004
(51) Int. Cl.: H01J 37/02

(54) **MOUNTING MECHANISM FOR PLASMA EXTRACTION APERTURE**
BEFESTIGUNGSVORRICHTUNG FÜR EINE PLASMA-EXTRAKTIONSBLENDE
MECANISME DE MONTAGE DESTINE A UNE OUVERTURE D'EXTRACTION DE PLASMA

(30) Priority: 07.01.2003 US 395720
(43) Date of publication of application: 05.10.2005
(73) Proprietor: Axcelis Technologies, Inc., Beverly, MA 01915 (US)
(72) Inventor: BENVENISTE, Victor, Gloucester, MA 01930 (US)
(74) Representative: Burke, Steven David
(86) International application number: PCT/US2004/000190
(87) International publication number: WO 2004/064100

(56) References cited:
- EP-A- 0 344 969
- US-A- 5 420 415
- US-B1- 6 417 511

## Description

### Field of the Invention

The present invention relates generally to ion implantation systems and more particularly to a mounting mechanism for a plasma extraction aperture in such a system.

### Background of the Invention

Ion implantation has become the technology preferred by industry to dope semiconductors with impurities in the large-scale manufacture of integrated circuits. Ion dose and ion energy are the two most important variables used to define an implant step. Ion dose relates to the concentration of implanted ions for a given semiconductor material. Typically, high current implanters (generally greater than 10 milliamps (mA) ion beam current) are used for high dose implants, while medium current implanters (generally capable of up to about 1 mA beam current) are used for lower dose applications.

Ion energy is the dominant parameter used to control junction depth in semiconductor devices. The energy levels of the ions that make up the ion beam determine the degree of depth of the implanted ions. High energy processes such as those used to form retrograde wells in semiconductor devices require implants of up to a few million electron volts (MeV), while shallow junctions may only demand ultra low energy (ULE) levels below one thousand electron volts (1 KeV).

A typical ion implanter comprises three sections or subsystems: (i) an ion source for outputting an ion beam, (ii) a beamline including a mass analysis magnet for mass resolving the ion beam, and (iii) a target chamber which contains the semiconductor wafer or other substrate to be implanted by the ion beam. The continuing trend toward smaller and smaller semiconductor devices requires a beamline construction that serves to deliver high beam currents at low energies. The high beam current provides the necessary dosage levels, while the low energy permits shallow implants. Source/drain junctions in semiconductor devices, for example, require such a high current, low energy application.

Ion sources in ion implanters typically generate an ion beam by ionizing within a source chamber a source gas, a component of which is a desired dopant element, and extracting the ionized source gas in the form of an ion beam. The ionization process is effected by an exciter, which may take the form of a thermally heated filament or a radio frequency (RF) antenna. A thermally heated filament thermionically emits high-energy electrons while an RF antenna delivers a high energy RF signal into the source chamber.

Either the high-energy electrons (in the case of the thermally heated exciter) or the RF signal (in the case of the RF exciter) is used to impart energy to, and thus ionize, the source gas in the source chamber. Examples of desired dopant elements of which the source gas is comprised include phosphorous (P) or arsenic (As). In an ion source utilizing a thermally heated filament for ionization, the source chamber typically attains temperatures on the order of 1000° C.

Ions generated within the source are extracted through an elongated source aperture or slit by an electric field generated by one or more energized extraction electrodes located outside of the source chamber. The source aperture and the extraction electrodes may be made of graphite. Each extraction electrode typically comprises a pair of spaced-apart elements forming an elongated extraction gap through which the ion beam travels. The extraction electrode is electrically biased negatively with respect to the source aperture (in the case of a positively charged ion beam). If more than one extraction electrode is used, the magnitude of the voltages on the plurality of electrodes is typically increased on each successive electrode moving downstream so as to provide an accelerating field for the ion beam.

In designing such an ion implanter, it is important to insure that the ion beam generated by and extracted from the ion source accurately follows a desired predetermined travel path. The position of the extraction electrode with respect to the source aperture is critical to achieving a beam path that coincides with the predetermined beam path. Precise alignment of the extraction electrode or electrodes with the source aperture is required.

The extraction electrodes are typically mounted on structure that extends from and is connected to the source housing. Heat generated by the operation of the ion source during implant processes causes thermal expansion of this structure which can result in misalignment of the extraction electrodes with the source aperture. Such misalignment may cause unwanted disruptions in the intended path of the ion beam and result in unwanted "beam steering", as well as distortions in the ion beam emittance quality which could impair its transport through the rest of the beamline.

Mechanisms for adjusting the position of the extraction electrodes with respect to the source aperture in ion implanters are known. One such mechanism is shown in the prior art Figure 1 (also see U.S. Patent No. 5,420,415 to Trueira and U.S. Patent No. 5,661,308 to Benveniste et al., both assigned to the assignee of the present invention). An extraction electrode assembly 2 is attached to an ion source 3 providing an aperture plate 4 having an aperture 6. The extraction electrode assembly 2 comprises four electrodes 8a, 8b, 8c, and 8d. Extraction electrode 8a is attached to the ion source 3, extraction electrode 8b is attached extraction electrode 8a, extraction electrode 8c is attached extraction electrode 8b, and extraction electrode 8d is attached extraction electrode 8c. Source aperture 6 and the apertures in the extraction electrodes are centered about an ion beam axis B.

Each of the four extraction electrodes 8a-8d is attached to its respective supporting structure in a manner that permits slight movement of the electrodes with respect to each other and the source aperture during operation of the implanter. Specifically, spring-loaded screws (not shown) are used as attachment devices at one end of each of the extraction electrodes, and ceramic balls 9 are pinned between adjacent electrodes (or between the first extraction electrode 8a and the ion source 3). The spring-loaded screws and the ceramic balls maintain the desired distance between adjacent extraction electrodes (or between the first extraction electrode 8a and the ion source 3). The ceramic balls permit slight adjustments in the alignment of extraction electrode gaps and the source aperture during the operation of the implanter at elevated temperatures, thereby accommodating thermal expansion, while maintaining this desired distance.

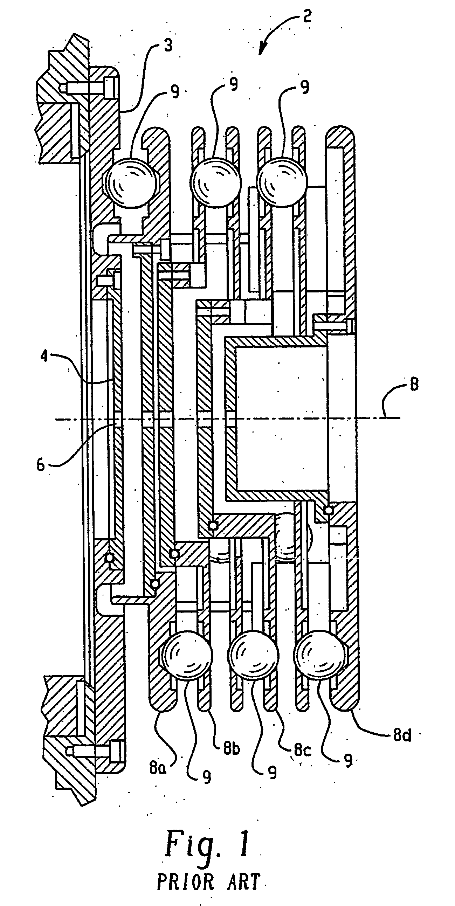

The alignment mechanism of Figure 1 is complex and requires precise adjustment, in the case of the spring-loaded screws. In addition, such alignment mechanisms are prone to failure. It is an object of the present invention, then, to provide an improved mechanism for maintaining precise positioning and alignment of an extraction electrode and a source aperture in an ion implanter, while accommodating the effects of thermal expansion encountered during operation of the implanter. It is further object to an improved mechanism for maintaining precise positioning and alignment between successive extraction electrodes in an ion implanter, while accommodating the effects of thermal expansion. It is yet a further object of the present invention to provide such a mechanism for an ion implanter that is easily maintained and that does not require precise adjustment.

EP 0344969 discloses an electron cyclotron resonance ion source for an ion implanter. A number of extraction electrodes (110-112) at an output end of the ionization chamber of the source are aligned during construction of the source by pushing parallel alignment plus (159) through openings of the electrodes.

### Summary of the Invention

An improved electrode subassembly for an ion implanter is provided as defined in claim 1. The subassembly comprises (i) a first generally planar electrode residing in a first plane and having a first aperture; (ii) a second generally planar electrode residing in a second plane generally parallel to the first plane and having a second aperture aligned with the first aperture; and (iii) a pair of connecting rods connecting the first generally planar electrode to the second generally planar electrode. The connecting rods permit generally parallel and slidable movement of the second generally planar electrode with respect to the first generally planar electrode.

The connecting rods are positioned in a non-parallel relationship to each other, so that the first and second electrodes when undergoing thermal expansion slide with respect to each other upon the non-parallel connecting rods, to increase or decrease a distance therebetween, while maintaining a parallel relationship. The connecting rods in the preferred embodiment are comprised of quartz, and are cylindrical in shape. The cylindrical quartz connecting rods are, positioned within corresponding cylindrical bores in the first and second electrodes. Preferably, the pair of connecting rods are oriented mutually orthogonally with respect to each other.

### Brief Description of the Drawings

Figure 1 is a cross sectional view of a prior art extraction assembly shown attached to an ion source aperture;
Figure 2 is a perspective view of an ion implantation system into which is incorporated one embodiment of an ion source/extraction electrode assembly constructed according to the principles of the present invention; and
Figure 3 is a cross sectional view of the ion source/extraction electrode assembly of the ion implantation system of Figure 2.

### Detailed Description of a Preferred Embodiment of the Invention

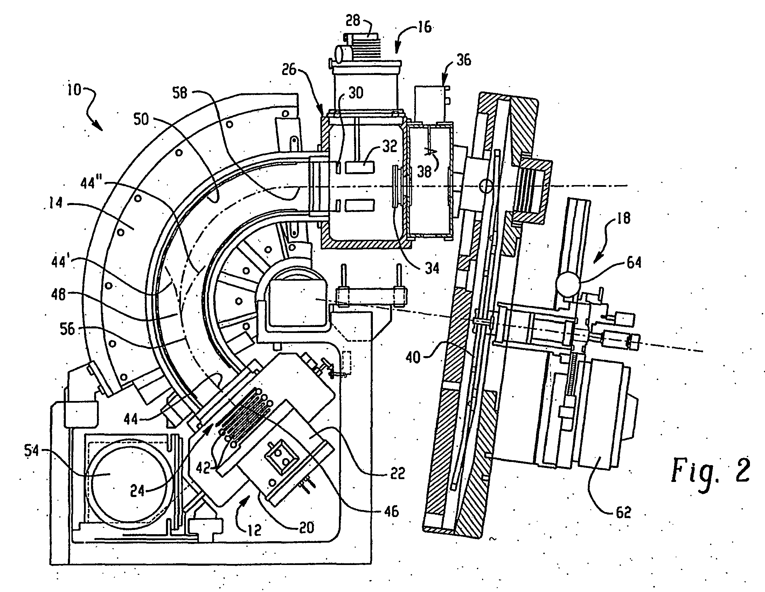

Referring now to the drawings, Figure 2 discloses an ion implanter, generally designated 10, which comprises an ion source 12, a mass analysis magnet 14, a beamline assembly 16, and a target or end station 18. One application of the present invention is in a low energy implanter, such as that shown in Figure 2, wherein the beamline assembly 16 is relatively short due to the tendency of a low energy beam to expand (*i.e.,* "blow-up") during propagation downstream. However, it is contemplated that the invention may be applied to other types of ion implanters having other types of ion sources.

The ion source 12 comprises a housing 20 which defines a plasma chamber 22, and an ion extractor assembly 24. The beamline assembly 16 includes (i) a resolver housing 26 which is evacuated by vacuum pump 28 and which contains a terminal aperture 30, a resolving aperture 32, and a flag Faraday 34; and (ii) a beam neutralizer 36 which contains an electron shower 38, none of which form a part of the present invention. Downstream of the beam neutralizer 36 is the end station 18, which includes a disk-shaped wafer support 40 upon which wafers to be treated are mounted. As used herein, wafer shall include any type of substrate, which may be implanted with an ion beam.

Energy is imparted to the ionizable dopant gas to generate ions within the plasma chamber 22. Generally, positive ions are generated, although the present invention is applicable to systems wherein negative ions are generated by the source. The positive ions are extracted from the plasma chamber 22 by the ion extractor assembly 24 that comprises at least one, and preferably a plurality of, electrodes 42. Accordingly, the ion extractor assembly 24 functions to extract a beam 44 of positive ions from the plasma chamber and accelerate the extracted ion beam toward the mass analysis magnet 14.

The mass analysis magnet 14 functions to pass only ions of an appropriate charge-to-mass ratio to the beamline assembly 16. The mass analysis magnet 14 includes a curved beam path 48 which is defined by an aluminum beam guide 50 connected to the source 12, evacuation of which is provided by a vacuum pumps 28 and 54. The ion beam 44 that propagates along this path is affected by the magnetic field generated by the mass analysis magnet 14. The magnetic field causes the ion beam 44 to move along the curved beam path 48, from a first or entrance trajectory 56 near the ion source 12 to a second or exit trajectory 58 near the resolving housing 26. Portion 44' and 44" of the beam 44 comprised of ions having an inappropriate charge-to-mass ratio are deflected away from the curved trajectory and into the walls of aluminum beam guide 50. In this manner, the magnet 14 passes to the beamline assembly 16 only those ions in the beam 44 that have the desired charge-to-mass ratio.

The disc shaped wafer support 40 at the end station 18 is rotated by motor 62. As is known in the art, the disk shaped support 40 is rotated at a constant angular velocity by motor 62, and support 40 is moved vertically (into and out of the page of Figure 2) by motor 64 and a lead screw (not shown).

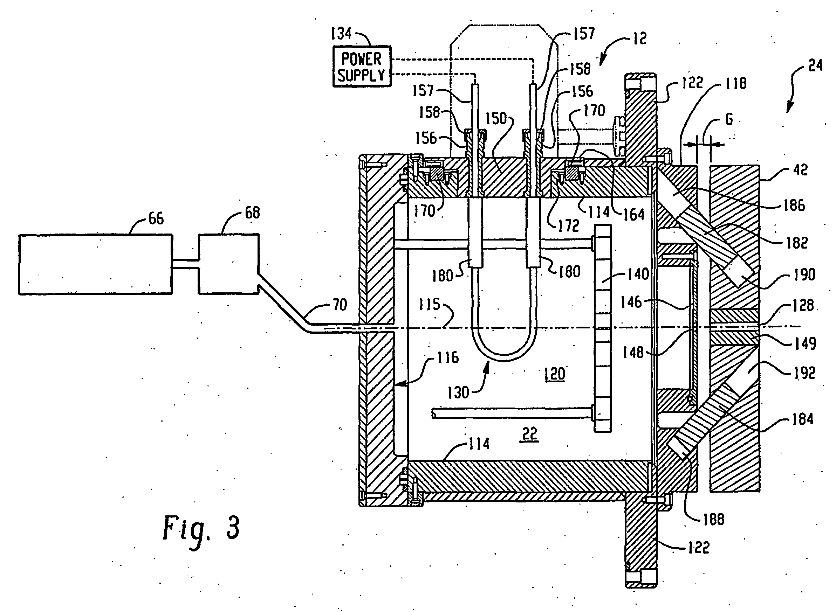

As shown in Figure 3, and explained further below, the present invention is incorporated into a mechanism for attaching the extractor assembly 24 to the ion source 12. Although the invention is shown in terms of a cold-walled, RF-powered source, the invention is applicable to other types of ion sources (e.g., hot-cathode, or microwave-powered). In addition, although Figure 3 shows only a single extraction electrode 42, it is contemplated that the invention may be implemented in an extract assembly comprising a multiple electrode configuration.

The plasma chamber 22 has an electrically conductive chamber wall 114 and generally planar end plates 116 and 118 that bound an ionization zone 120 in a chamber interior. Sidewall 114 is circularly symmetric about a center axis 115 of the plasma chamber 22. End plate 118 is connected to a plasma chamber support 122, and includes a source aperture insert 146 having at least one source aperture 148 through which the ion beam is extracted. The source aperture insert 136 may be made of graphite.

The extraction electrode 42 is generally planar and includes an electrode aperture insert 149 having at least one extraction aperture 128. The electrode aperture insert may be made of graphite. The at least one extraction aperture 128 aligns with the at least one source aperture 148 in the source aperture insert 146. Although only one such aperture is shown for each element in Figure 3, each aperture 128, 148 may comprise a plurality of apertures arranged in a specified pattern. Alternatively, a single elongated slit may be provided as each aperture. Still further, the extraction electrode 42 may comprise a pair of opposed electrode halves separated by a space therebetween that functions as the extraction slit or aperture.

In one type of operation, ionizable dopant gas is injected directly into the plasma chamber 22 from a source 66 of compressed gas by means of a mass flow controller 68 through conduit 70. Typical source elements are phosphorous (P) and arsenic (As), which are often provided in gaseous form in combination with other elements, for example, phosphorous in the form of phosphine (PH₃), and arsenic in the form of arsine (AsH₃).

A power supply 134 outside the plasma chamber 22 energizes a metallic antenna 130 with a radio frequency (RF) signal of approximately 13.56 megahertz (MHz) to set up an alternating electric current in the metallic antenna that to induce an ionizing electric field within the plasma chamber 22. The plasma chamber 22 may also include a magnetic filter assembly 140 extending through a region of the chamber interior between the antenna 130 and the source aperture insert 146.

The antenna 130 is positioned within the wall 114 of the plasma chamber 22 by a removable support plate 150. The support plate 150 also defines two through passageways that accommodate two vacuum pressure fittings 156. After elongated leg segments 157 of the antenna 130 are pushed through the fittings, end caps 158 are screwed onto the fittings to seal the region of contact between the fittings 156 and the leg segments 157.

A flanged portion 164 of the plate 150 overlies a ring magnet 170 that surrounds the cutout in the wall 114 and that is attached to the wall 114 by connectors 172. Two shields 180 positioned over the antenna prevent the region of the antenna near the support plate 150 from being coated with sputtered material during operation of the ion implanter.

The present invention is embodied in an improved mechanism for maintaining precise positioning and alignment of the extraction electrode 42 and the source aperture insert 146, while accommodating the effects of thermal expansion encountered during operation of the ion implanter 10. The improved mechanism, in the preferred embodiment, comprises a pair of elongate rods 182, 184 that fit snugly into corresponding bores in the end plate 118 and the extraction electrode 42. Specifically, one end of rod 182 fits into bore 186 in the end plate 118, and the opposite end of rod 182 fits into bore 190 in the extraction electrode 42. Similarly, one end of rod 184 fits into bore 188 in the end plate 118, and the opposite end of rod 184 fits into bore 192 in the extraction electrode 42.

The rods 182 and 184 in the preferred embodiment are constructed from quartz or a similar material. The electrically insulative nature of quartz permits the source (end plate 118) and the extraction electrode 42 to operate at different voltages. Typically, to extract a positively charged ion beam through source aperture 148, the extraction electrode 42 is biased to a voltage potential that is negative with respect to the source (end plate 118). Although certain ceramics have acceptable thermal and electrically insulative qualities that make them suitable for constructing the rods 182 and 184, quartz has been found to be more immune to metal deposition than ceramic.

The quartz rods 182 and 184 may be machined to close tolerances. The bores 186, 188, 190 and 192 in the source end plate 118 and the extraction electrode 42 may be similarly machined. Both the end plate 118 and the extraction electrode 42 may be made of aluminum. Alternatively, these members may be made of graphite if aperture inserts are not utilized.

In constructing a subassembly comprising the end plate 118 and the extraction electrode 42, a spacer (not shown) of width G (see Figure 3) is positioned between these two components which are then clamped together. Using the same boring process, bore 186 is milled completely through plate 118 and bore 190 is milled partially through electrode 42. Similarly, bore 192 is milled completely through electrode 42 and bore 188 is milled partially through plate 118. Preferably, these blind bores are milled orthogonally (at 90 degrees) with respect to each other (45 degrees with respect to the path 115 of the ion beam).

The quartz rods 182, 184 may then be slip fit (cold) into their respective bores. Because the bores are blind, having one end open and one end closed, gravity will keep the rods in place within their respective bores. The spacers can then be removed, leaving a gap G between the end plate 188 and the extraction electrode 42. No bushings, adjusting screws or other hardware is required. In addition, shielding features (not shown) may be added so that there is no direct line of sight from the exposed portions of the quartz rods (within the gap G) and the ion beam.

Because the ion source 12 operates at a high temperature, the end plate 118 and the extraction electrode 42 may thermally expand. The connecting rods 182, 184 permit these two components to move toward and away from each other, to accommodate differential thermal expansion, while maintaining the parallel relationship of the generally planar end plate 188 and extraction electrode 42. As such, the desired alignment of the source aperture 148 and the extraction aperture 128 is maintained. To the extent that the gap G between these two components changes and alters the ion beam current extracted from the source, the voltage on the electrode 42 may be correspondingly changed.

Accordingly, a preferred embodiment of a method and system for mounting a plasma extraction aperture to a source aperture has been described. With the foregoing description in mind, however, it is understood that this description is made only by way of example. It is contemplated that, for another example, the mechanism for attaching the extraction electrode to the source end plate may be duplicated and used for connecting downstream extraction electrodes in the extractor assembly to each other. Thus, the invention is not limited to the particular embodiments described herein, and various rearrangements, modifications, and substitutions may be implemented with respect to the foregoing description without departing from the scope of the invention as defined by the following claims.

## Claims

1. An electrode subassembly for an ion implanter (10), comprising:
(i) a first generally planar electrode (118) residing in a first plane and having a first aperture (146);
(ii) a second generally planar electrode (42) residing in a second plane generally parallel to said first plane and having a second aperture aligned with said first aperture;
(iii) a pair of connecting rods (182, 184) connecting the first generally planar electrode (118) to the second generally planar electrode (42), said connecting rods permitting generally parallel and slidable movement of the second generally planar electrode with respect to the first generally planar electrode, said connecting rods (182, 184) positioned in a non-parallel relationship to each other; whereby said first and second electrodes (42, 118) when undergoing thermal expansion slide with respect to each other upon said non-parallel connecting rods (182, 184), to increase or decrease a distance therebetween, while maintaining a parallel relationship.

2. The electrode assembly of claim 1, wherein said connecting rods (182, 184) are comprised of quartz.

3. The electrode assembly of claim 2, wherein said connecting rods (182, 184) are cylindrical in shape, and wherein the cylindrical connecting rods are positioned within corresponding cylindrical bores (186, 188, 190, 192) in said first and second electrodes (118,42).

4. The electrode assembly of claim 3, wherein said pair of connecting rods (182, 184) are oriented mutually orthogonally with respect to each other.

5. The electrode assembly of claim 3, wherein at least one of said apertures is surrounded by graphite.

6. An ion source (12), comprising:
(i) a housing (20) defining a plasma chamber (22) in which an ionized plasma is generated; and
(ii) an electrode subassembly as claimed in any of claims 1 to 5, the first generally planar electrode (118) being attached to the housing (20).

## Patentansprüche

1. Elektrodenbaugruppe für einen Ionenimplantierer (10) umfassend:
(i) eine erste im Allgemeinen flächige Elektrode (11.8), die sich in einer ersten Ebene befindet und eine erste Öffnung (146) hat;
(ii) eine zweite im Allgemeinen flächige Elektrode (42), die sich in einer zweiten Ebene befindet, die im Allgemeinen parallel zur ersten Ebene ist, und eine zweite Öffnung hat, die an der ersten Öffnung ausgerichtet ist;
(iii) ein Paar Verbindungsstäbe (182, 184), die die erste im Allgemeinen flächige Elektrode (118) mit der zweiten im Allgemeinen flächigen Elektrode (42) verbindet, wobei die Verbindungsstäbe eine im Allgemeinen parallele und verschiebbare Bewegung der zweiten im Allgemeinen flächigen Elektrode im Hinblick auf die erste im Allgemeinen flächige Elektrode ermöglicht, wobei die verbindungsstäbe (182, 184) in einer nicht-parallelen Beziehung zueinander positioniert sind; wobei die ersten und zweiten Elektroden (42, 118), wenn sie sich thermisch ausdehnen, in Beziehung zueinander auf den nicht-parallelen Verbindungsstäben (182, 184) gleiten, um einen Abstand dazwischen zu erhöhen oder verringern, während eine parallele Beziehung beibehalten wird.

2. Elektrodenbaugruppe nach Anspruch 1, wobei die Verbindungsstäbe (182, 184) aus Quartz bestehen.

3. Elektrodenbaugruppe nach Anspruch 2, wobei die Verbindungsstäbe (182, 184) eine zylindrische Form haben und wobei die zylindrischen Verbindungsstäbe in entsprechenden zylindrischen Bohrungen (186, 188, 190, 192) in den ersten und zweiten Elektroden (118, 42) positioniert sind.

4. Elektrodenbaugruppe nach Anspruch 3, wobei das Paar aus Verbindungsstäben (182, 184) rechtwinklig in Beziehung zueinander angeordnet ist.

5. Elektrodenbaugruppe nach Anspruch 3, wobei mindestens eine der Öffnungen mit Graphit ummantelt ist.

6. Ionenquelle (12) umfassend:
(i) ein Gehäuse (20), das eine Plasmakammer (22) definiert, in der ein ionisiertes Plasma erzeugt wird; und
(ii) eine Elektrodenbaugruppe nach einem der Ansprüche 1 bis 5, wobei die erste im Allgemeinen flächige Elektrode (118) an das Gehäuse (20) angebracht ist.

## Revendications

1. Sous-ensemble d'électrodes pour un implanteur d'ions (10), comprenant :
(i) une première électrode globalement plane (118) résidant dans un premier plan et ayant une première ouverture (196),
(ii) une seconde électrode globalement plane (42) résidant dans un second plan globalement parallèle audit premier plan et ayant une seconde ouverture alignée sur ladite première ouverture ;
(iii) une paire de bielles (182, 184) raccordant la première électrode globalement plane (118) à la seconde électrode globalement plane (42) ; lesdites bielles permettant un déplacement globalement parallèle et coulissant de la seconde électrode globalement plane par rapport à la première électrode globalement plane, lesdites bielles (182, 184) étant positionnées selon une relation non parallèle l'une par rapport à l'autre ; moyennant quoi lesdites première et seconde électrodes (42, 118), quand elles subissent une dilatation thermique, coulissent l'une par rapport à l'autre sur lesdites bielles non parallèles (182, 184), afin d'augmenter ou de diminuer la distance les séparant, tout en maintenant une relation parallèle.

2. Ensemble d'électrodes selon la revendication 1, dans lequel lesdites bielles (182, 184) sont composées de quartz.

3. Ensemble d'électrodes selon la revendication 2, dans lequel lesdites bielles (182, 184) sont de forme cylindrique, et dans lequel les bielles cylindriques sont placées dans des alésages cylindriques correspondants (186, 188, 190, 192) dans lesdites première et seconde électrodes (118, 42).

4. Ensemble d'électrodes selon la revendication 3, dans lequel lesdites bielles (182, 184) sont orientées de façon mutuellement orthogonale l'une par rapport à l'autre.

5. Ensemble d'électrodes selon la revendication 3, dans lequel au moins l'une desdites ouvertures est entourée de graphite.

6. Source d'ions (12), comprenant :
(i) un logement (20) définissant une chambre de plasma (22) dans laquelle un plasma ionisé est généré ; et
(ii) un sous-ensomble d'électrodes selon l'une quelconque des revendications 1 à 5, l'électrode globalement plane finale (118) étant fixée au logement (20).
